# EUROPEAN PATENT APPLICATION

(11) **EP 1 753 236 A1**
(43) Date of publication of application: **14.02.2007**
(21) Application number: 06118844.7
(22) Date of filing: 11.08.2006
(51) Int. Cl.: H04N 5/53, H04B 1/06, H04H 1/00

(54) **T-DMB and DAB low intermediate frequency receiver**

(30) Priority: 13.08.2005 KR 20050074552; 17.08.2005 KR 20050075309; 22.08.2005 KR 20050076765
(71) Applicant: Integrant Technologies Inc., Gyeonggi-do 463-810 (KR)
(72) Inventor: Kim, Bonkee Mokryeon Maeul Yeongnam Apt. 502-603, Seongnam-si, Gyeonggi-do (KR); Kim, Bo-Eun Sejong Lizencivil 207-103, Yongin-si, Gyeonggi-do (KR)
(74) Representative: Joly, Jean-Jacques

(57) **Abstract**

A terrestrial-digital multimedia broadcasting (T-DMB) and digital audio broadcasting (DAB) low intermediate frequency (IF) receiver comprises a low noise amplifier (LNA) 202, an image rejection down-conversion mixer 203, a low pass filter 204, an amplifier 205, a local oscillator 208, a phase-locked loop 209, and an automatic gain controller (AGC) 211. Particularly, the LNA, the image rejection down-conversion mixer, the low pass filter, the amplifier, the AGC, the local oscillator, and the phase-locked loop are integrated in monolithic semiconductor integrated circuit substrate. The AGC supplies a gain control signal to the LNA and the amplifier according to the magnitude of the RF signal, and the gain control signal is controlled by a null control signal based on a null signal comprised in a received radio frequency (RF) signal.

## Description

### BACKGROUND OF THE INVENTION

### Field of the Invention

The present invention relates to a terrestrial-digital multimedia broadcasting (T-DMB) and digital audio broadcasting (DAB) receiver.

### Description of the Background Art

A conventional receiver uses a super-heterodyne mode that converts a received signal into a signal at an intermediate frequency (IF) band and then into a signal at a baseband.

The IF is used to improve the performance of the receiver using a filter that effectively filters a specific frequency band. A surface acoustic wave (SAW) filter is generally used as the aforementioned filter.

A conventional DAB receiver uses an L-band of the radio frequency (RF) spectrum ranging from 1,450 MHz to 1,492 MHz. On the other hand, a conventional T-DMB receiver uses a Band-III band of the RF spectrum ranging from 174 MHz to 245 MHz. Also, the conventional DAB and T-DMB receivers use an IF of 38.912 MHz and have a channel bandwidth of 1.536 MHz.

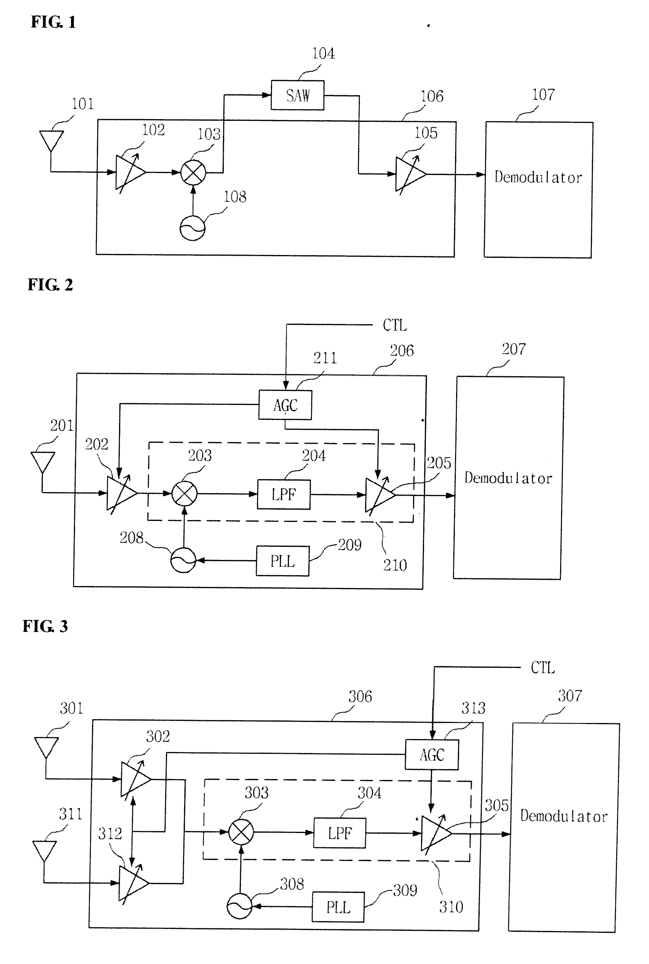

FIG. 1 illustrates a simplified block diagram of a conventional receiver.

A RF signal that is received by an antenna 101 is supplied to a low noise amplifier (LNA) 102. An output signal of the LNA 102 is transmitted to a mixer 103, which subsequently moves the transmitted signal to the IF band.

An output signal of the mixer 103 passes through a band-pass filter 104 and is transmitted to an amplifier 105. A demodulator 107 receives an output signal of the amplifier 105. A local oscillator 108 generates a frequency to make the received RF signal move to the IF band and, supplies the generated frequency to the mixer 103.

The band-pass filter 104 is a SAW filter that is generally used in the typical super-heterodyne mode.

The LNA 102, the mixer 103, the amplifier 105, and the local oscillator 108 are integrated into a single receiver chip 106, and the band-pass filter 104 (i.e., the SAW filter) is disposed outside the receiver chip 106.

The SAW filter is a filter for telecommunications using mechanical vibrations from a piezoelectric substrate. On the piezoelectric substrate, two slit patterned metal plates are arranged to face in opposite direction on both sides of the piezoelectric substrate. When an electric signal is inputted from one direction, a surface acoustic wave is generated on the piezoelectric substrate.

The surface acoustic wave, which is also called "mechanical vibration," is converted into an electric signal in the opposite direction to the input direction. If the surface acoustic wave of the piezoelectric substrate has a different frequency from the inputted electric signal, the signal transmission does not take place. As a result, the SAW filter functions as a band-pass filter that passes only a frequency identical to a mechanical-physical frequency of the SAW filter.

As compared with a filter using the LC resonance principle, the SAW filter generally passes a very narrow bandwidth, and thus, can be effective to select a desired signal frequency with a narrow bandwidth since the SAW filter can almost completely filter out unnecessary signal frequencies.

However, the SAW filter is a mechanical filter, and thus, often has a limitation in reducing the volume. As illustrated in FIG. 1, in the case that the receiver using the band-pass filter 104 (i.e., the SAW filter) is constructed in a single integration chip, the SAW filter usually cannot be integrated therein, thereby being placed outside the receiver chip 106.

Since the SAW filter is expensive, the total manufacturing cost for the receiver often increases.

Therefore, when such a receiver using the SAW filter is implemented to a mobile telecommunications terminal, the SAW filter may become a main factor that increases the price of the receiver. Also, it may be difficult to integrate the receiver into a single chip.

A receiver that receives a single RF signal by a single antenna can receive a single corresponding frequency band. Therefore, when at least two frequency bands need to be received, a number of receiver chips are necessary to receive the frequency bands individually. As a result, the overall volume of the telecommunications devices may increase, and the manufacturing costs may also increase.

A signal that is received by the antenna of the receiver usually includes a noise signal. An attenuation level of the signal varies differently depending on the transmission path through the channels. Hence, an automatic gain controller (AGC) is employed to control the received signal to have the consistent magnitude.

However, for a signal at a certain frequency band, an information contained signal section is often not consecutive, and an information contained section and a null section that does not contain information coexist. Since the signal at the null section has the smaller magnitude than that at the information contained section, an amplification gain of the amplifier increases when the AGC operates at the null section. After the null section, the increased amplification gain is maintained at the information contained section. As a result, it may difficult to maintain the consistent magnitude of the signal received at the information contained section.

### SUMMARY OF THE INVENTION

Accordingly, one embodiment of the present invention is directed to provide a T-DMB and DAB low IF receiver that can be easily integrated into a single chip and manufactured at low costs.

Another embodiment of the present invention is directed to provide a dual band T-DMB and DAB low IF receiver that can be easily integrated into a single chip and manufactured at low costs.

Still another embodiment of the present invention is directed to provide a T-DMB and DAB low IF receiver and a dual band T-DMB and DAB low IF receiver that can maintain the consistent magnitude of a received RF signal.

A T-DMB and DAB low IF receiver according to an embodiment of the present invention comprises a low noise amplifier (LNA) suppressing a noise signal of a received radio frequency (RF) signal and amplifying the received RF signal, wherein the received RF signal includes a T-DMB signal or a DAB signal, an image rejection down-conversion mixer converting a frequency band of the RF signal outputted from the LNA into a low IF band and rejection an image frequency band, a low pass filter filtering a low frequency band of a signal outputted from the image rejection down-conversion mixer, an amplifier amplifying a signal outputted from the low pass filter, a local oscillator generating a frequency for the down-conversion and supplying the frequency to the image rejection down-conversion mixer, a phase-locked loop moving the frequency of the local oscillator to a certain frequency and locking the certain frequency, and an automatic gain controller (AGC) controlling amplification gains of the LNA and the amplifier, wherein the LNA, the image rejection down-conversion mixer, the low pass filter, the amplifier, the AGC, the local oscillator, and the phase-locked loop are integrated in a monolithic semiconductor integrated circuit substrate; the AGC supplies a gain control signal to the LNA and the amplifier according to the magnitude of the RF signal; and the gain control signal is controlled by a null control signal based on a null signal comprised in the RF signal.

In the embodiment of the present invention, the null control signal may control the gain control signal at a section of the null signal.

In the embodiment of the present invention, the null control signal may control the gain control signal to have a consistent signal level at the section of the null signal.

In the embodiment of the present invention, the signal level may be a signal level of the gain control signal prior to receiving the null signal.

In one embodiment of the present invention, the RF signal of the LNA may comprise a signal at one frequency band of a Band-III ranging between about 174 MHz and about 245 MHz or an L-band ranging between about 1,450 MHz and about 1,492 MHz.

The configuration according to the embodiment of the present invention allows the removal of the SAW filter without degrading the performance of the receiver, and thus, the manufacturing cost can be reduced and the easier single-chip implementation can be achieved.

A dual band terrestrial-digital multimedia broadcasting (T-DMB) and digital audio broadcasting (DAB) low intermediate frequency (IF) receiver according to another embodiment of the present invention comprises: a first low noise amplifier (LNA) suppressing a noise signal of a received first radio frequency (RF) signal and amplifying the received first RF signal, wherein the received first RF signal includes a T-DMB signal, a second low noise amplifier (LNA) suppressing a noise signal of a received second radio frequency (RF) signal and amplifying the received second RF signal, wherein the received second RF signal includes a DAB signal, an image rejection down-conversion mixer converting frequency bands of the first and second RF signals respectively outputted from the first and second LNAs into a low IF band and rejection an image frequency band, a low pass filter filtering a low frequency band of a signal outputted from the image rejection down-conversion mixer, an amplifier amplifying a signal outputted from the low pass filter, a local oscillator generating a frequency for the down-conversion and supplying the frequency to the image rejection down-conversion mixer, a phase-locked loop moving the frequency of the local oscillator to a certain frequency and locking the certain frequency, and an automatic gain controller (AGC) controlling amplification gains of the first and second LNAs and the amplifier, wherein the first and second LNAs, the image rejection down-conversion mixer, the low pass filter, the amplifier, the AGC, the local oscillator, and the phase-locked loop are integrated in a monolithic semiconductor integrated circuit substrate; the AGC supplies a gain control signal to the first and second LNAs and the amplifier according to the magnitude of the first and second RF signals; and the gain control signal is controlled by a null control signal based on a null signal comprised in each of the first and second RF signals.

In the other embodiment of the present invention, the null control signal may control the gain control signal at a section of the null signal.

In the other embodiment of the present invention, the null control signal may control the gain control signal to have a consistent signal level at the section of the null signal.

In the other embodiment of the present invention, the signal level may be a signal level of the gain control signal prior to receiving the null signal.

In the other embodiment of the present invention, the first RF signal of the first LNA may comprise a signal at a Band-III frequency band ranging between about 174 MHz and about 245 MHz, and the second RF signal of the second LNA may comprise a signal at an L-band frequency band ranging between about 1,450 MHz and about 1,492 MHz.

The configuration according to the other embodiment of the present invention allows the removal of the SAW filter without degrading the performance of the receiver and simultaneously the receipt of the signals at the two frequency bands. Thus, the manufacturing cost can be reduced and the easier single-chip implementation can be achieved.

### BRIEF DESCRIPTION OF THE DRAWINGS

The invention will be described in detail with reference to the following drawings in which like numerals refer to like elements.

FIG. 1 illustrates a simplified block diagram of a conventional receiver using a SAW filter;

FIG. 2 illustrates a simplified block diagram of a T-DMB and DAB low IF receiver according to an embodiment of the present invention;

FIG. 3 illustrates a simplified block diagram of a dual band T-DMB and DAB low IF receiver according to an embodiment of the present invention; and

FIG. 4 illustrates a control signal and a received signal including a null section in the case of using a T-DMB and DAB low IF receiver or a dual band T-DMB and DAB low IF receiver according to an embodiment of the present invention.

### DETAILED DESCRIPTION OF EMBODIMENTS

Exemplary embodiments of the present invention will be described in a more detailed manner with reference to the drawings.

FIG. 2 illustrates a simplified block diagram of a T-DMB and DAB low IF receiver according to an embodiment of the present invention.

The receiver comprises an LNA 202, an image rejection down-conversion mixer 203, a low pass filter 204, an amplifier 205, a local oscillator 208, a phase-locked loop 209, and an AGC 211. The receiver is particularly a T-DMB and DAB low IF receiver in which the LNA 202, the image rejection down-conversion mixer 203, the low pass filter 204, the amplifier 205, the local oscillator 208, the phase-locked loop 209, and the AGC 211 are integrated into a single chip, i.e., a receiver chip 206.

An antenna 201 receives a RF signal and transmits the RF signal to the LNA 202 to suppress a noise signal and amplify the RF signal. An output signal of the LNA 202 is transmitted to the image rejection down-conversion mixer 203 that removes an image frequency component and performs a down-conversion of a frequency band of the RF signal into a low IF band.

The low pass filter 204 that filters a signal at the low frequency band receives an output signal of the image rejection down-conversion mixer 203. An output signal of the low pass filter 204 is transmitted to the amplifier 205, and the demodulator 207 receives an output signal of the amplifier 205.

The local oscillator 208 generates a frequency that allows the down-conversion of the RF signal into the low IF signal by the image rejection down-conversion mixer 203. The generated frequency is provided to the image rejection down-conversion mixer 203. The phase-locked loop 209 supplies a signal to the local oscillator 208 to move and lock the frequency generated by the local oscillator 208.

The AGC 211 controls amplification gains of the LNA 202 and the amplifier 205.

The receiver receives a signal that is attenuated as passing through channels. Particularly, the attenuation level varies depending on the receipt conditions.

The AGC 211 maintains a certain intensity level of the signal by controlling the amplification gains of the LNA 202 and the amplifier 205.

For a signal at a certain frequency band, an information contained signal section is not often consecutive, and an information contained section and a null section that does not contain information coexist. The magnitude of the signal at the null section is usually smaller than that at the information contained section. If the AGC 211 operates at the null section as same as at the information contained section, the amplification gain of the LNA 202 or the amplifier 205 at the null section increases, and the increasing amplification gain is maintained even at the information contained section after the null section. As a result, it is often difficult to obtain an appropriate level of the amplification.

The AGC 211 supplies the LNA 202 or the amplifier 205 with a gain control signal that can maintain a consistent level of the amplification gain of the LNA 202 or the amplifier 205 according to the magnitude of the RF signal inputted to the receiver.

A null control signal CTL controls the gain control signal according to the null section of the RF signal inputted to the receiver.

More specifically, the null control signal CTL controls the gain control signal based on the null section, and the amplification gain of the LNA 202 or the amplifier 205 according to the magnitude of the signal.

Although FIG. 2 illustrates the case that the null control signal CTL is supplied from outside of the receiver chip 206, the null control signal CTL may be generated inside of the receiver chip 206.

Due to the gain control signal and the null control signal CTL, the gain of the LNA 202b or the amplifier 205b can be maintained at a consistent level.

Therefore, the null control signal CTL stops the AGC 211 from controlling the amplification gain of the LNA 202 or the amplifier 205 during the receipt of the null signal, or maintains a consistent level of a certain gain control signal or a gain control signal prior to receiving a null symbol. That is, the null control signal CTL controls the amplification gain not to increase abnormally at the null section.

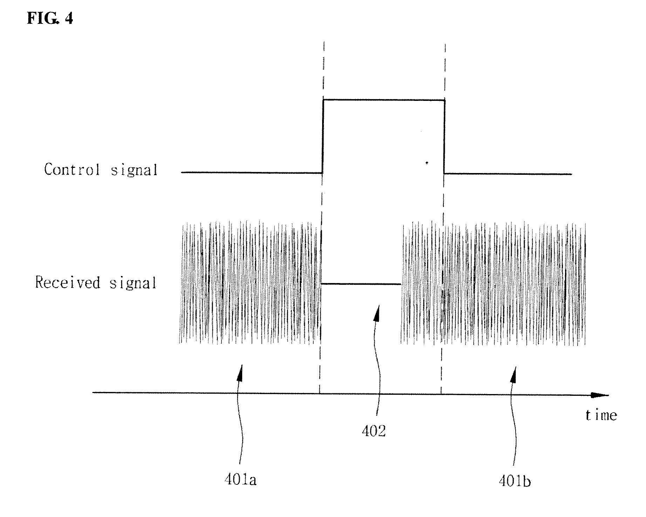

Detailed description of the null signal will be provided in FIG. 4 later.

The LNA 202 and the amplifier 205 may comprise a programmable gain amplifier or a variable gain amplifier.

According to the embodiment of the present invention, the T-DMB and DAB low IF receiver receives a range of frequencies at the Band-III of the frequency spectrum between about 174 MHz and about 245 MHz or at the L-band of the frequency spectrum between about 1,450 MHz and about 1,492 MHz and supplies a range of frequencies between about 0.768 MHz and about 0.960 MHz as a center frequency to the output terminal of the receiver.

A band width of the frequency at the output terminal of the receiver in the present embodiment is about 1.536 MHz. The frequency at the output terminal of the receiver according to the embodiment of the present invention is limited to about 768 kHz or more because a part of the frequency component at the output terminal of the receiver is likely to enter into a negative frequency region when the center frequency is about 768 kHz or less in the case that the band width of the frequency at the output terminal of the receiver is about 1.536 MHz.

Also, according to the embodiment of the present invention, the center frequency at the output terminal of the receiver is limited to about 0.960 MHz (i.e., the upper limit). The reason for setting this upper limit is because when the center frequency is about 0.960 MHz or more, adjacent signals may be pertained to the intended signal since the guard band has a frequency of about 0.192 MHz or 0.176 MHz.

Particularly, the output terminal of the receiver chip 206 may have a center frequency of about 850 kHz.

The demodulator 207 receives a signal of the output terminal of the receiver.

FIG. 3 illustrates a simplified block diagram of a dual band T-DMB and DAB low IF receiver according to another embodiment of the present invention.

The receiver comprises a first LNA 302, a second LNA 312, an image rejection down-conversion mixer 303, a low pass filter 304, an amplifier 305, a local oscillator 308, a phase-locked loop 309, and an AGC 313. The receiver is particularly a dual band T-DMB and DAB low IF receiver in which the first and second LNAs 302 and 312, the image rejection down-conversion mixer 303, the low pass filter 304, the amplifier 305, the local oscillator 308, the phase-locked loop 309, and the AGC 313 are integrated into a single chip, i.e., a receiver chip 306.

A first antenna 301 receives a first RF signal and transmits the first RF signal to the first LNA 302 to suppress a noise signal and amplify the first RF signal. A second antenna 31 receives a second RF signal and transmits the second RF signal to the second LNA 312 to suppress a noise signal and amplify the second RF signal.

An output signal of the first LNA 302 and an output signal of the second LNA 312 are transmitted to the image rejection down-conversion mixer 303 that removes an image frequency component and performs the down-conversion of a frequency band pertained to each of the first and second RF signals into a low IF band.

The low pass filter 304 that filters a signal at the low frequency band receives an output signal of the image rejection down-conversion mixer 303. An output signal of the low pass filter 304 is transmitted to the amplifier 305, and the demodulator 307 receives an output signal of the amplifier 305.

The local oscillator 308 generates a frequency that allows the down-conversion of the first and second RF signals into the low IF signal by the image rejection down-conversion mixer 303. The generated frequency is provided to the image rejection down-conversion mixer 303. The phase-locked loop 309 supplies a signal to the local oscillator 308 to move and lock the frequency generated by the local oscillator 308.

The AGC 313 controls amplification gains of the first and second LNAs 302 and 312 and the amplifier 305.

The receiver receives a signal that is attenuated as passing through channels. Particularly, the attenuation level varies depending on the receipt conditions.

The AGC 313 maintains a certain intensity level of the signal by controlling the amplification gains of the first and second LNAs 302 and 312 and the amplifier 305.

For a signal at a certain frequency band, an information contained signal section is not often consecutive, and an information contained section and a null section that does not contain information coexist. The magnitude of the signal at the null section is usually smaller than that at the information contained section. If the AGC 313 operates at the null section as same as at the information contained section, the amplification gain of the first and second LNAs 302 and 312 or the amplifier 305 at the null section increases, and the increasing amplification gain is maintained even at the information contained section after the null section. As a result, it is often difficult to obtain an appropriate level of the amplification.

The AGC 313 supplies the first and second LNAs 302 and 312 or the amplifier 305 with a gain control signal that can maintain a consistent level of the amplification gain of the first and second LNAs 302 and 312 or the amplifier 305 according to the magnitude of each of the first and second RF signals inputted to the receiver.

A null control signal CTL controls the gain control signal according to the null section of each of the first and second RF signals inputted to the receiver.

More specifically, the null control signal CTL controls the gain control signal based on the null section, and the amplification gain of the first and second LNAs 302 and 312 or the amplifier 305 according to the magnitude of the signal.

Although FIG. 3 illustrates the case that the null control signal CTL is supplied from outside of the receiver chip 306, the null control signal CTL may be generated inside of the receiver chip 306.

Due to the gain control signal and the null control signal CTL, the gain of the first and second LNAs 302 and 312 or the amplifier 305 can be maintained at a consistent level.

Therefore, the null control signal CTL stops the AGC 313 from controlling the amplification gain of the first and second LNAs 302 and 312 or the amplifier 305 during the receipt of the null signal, or maintains a consistent level of a certain gain control signal or a gain control signal prior to receiving a null symbol. That is, the null control signal CTL controls the amplification gain not to increase abnormally at the null section.

Detailed description of the null signal will be provided in FIG. 4 later.

The first and second LNAs 302 and 312 and the amplifier 305 may comprise a programmable gain amplifier or a variable gain amplifier.

According to the present invention, the first antenna 301 of the dual band T-DMB and DAB low IF receiver particularly receives a range of frequencies at the Band-III of the frequency spectrum, and the second antenna 311 thereof receives a range of frequencies at the L-band of the frequency spectrum. The first and second antennas 301 and 311 performs the down-conversion of the received signal frequencies into a center frequency ranging from about 0.768 MHz to about 0.960 MHz, and this center frequency is supplied to an output terminal of the receiver.

A band width of the frequency at the output terminal of the receiver in the present embodiment is about 1.536 MHz. The frequency at the output terminal of the receiver according to the other embodiment of the present invention is limited to about 768 kHz or more because a part of the frequency component at the output terminal of the receiver is likely to enter into a negative frequency region when the center frequency is about 768 kHz or less in the case that the band width of the frequency at the output terminal of the receiver is about 1.536 MHz.

Also, according to the other embodiment of the present invention, the center frequency at the output terminal of the receiver is limited to about 0.960 MHz (i.e., the upper limit). The reason for setting this upper limit is because when the center frequency is about 0.960 MHz or more, adjacent signals may also be comprised since the guard band has the minimum frequency of about 0.192 MHz or 0.176 MHz according to the specification set differently from country to country using a frequency resource.

The phase-locked loop 309 transmits the signal to allow the down-conversion of the received signal frequency at the Band-III or at the L-band into the center frequency ranging from about 0.768 MHz to about 0.960 MHz and then the transmission of the converted signal to the output terminal of the receiver.

Therefore, the dual band T-DMB and DAB low IF receiver according to the other embodiment of the present invention receives the signals at the two frequency bands (i.e., the Band-III band and the L-band).

In the case of receiving the signal at the Band-III of the frequency spectrum, the signal goes sequentially through the first antenna 301, the first LNA 302, the image rejection down-conversion mixer 303, the low pass filter 304, and the amplifier 305. In the case of receiving the signal at the L-band of the frequency spectrum, the signal goes through the second antenna 311, the second LNA 312, the image rejection down-conversion mixer 303, the low pass filter 304, and the amplifier 305.

Particularly, the output terminal of the receiver chip 306 may have a center frequency of about 850 kHz.

The demodulator 307 receives a signal of the output terminal of the receiver.

FIG. 4 illustrates a null control signal and a received RF signal including a null section in the case of using a dual band T-DMB and DAB low IF receiver according to an embodiment of the present invention.

FIG. 4 illustrates the null control signal and the received RF signal including the null section to describe the embodiments illustrated in FIGS. 2 and 3, and thus, can be applied commonly to FIGS. 2 and 3. Particularly, the null control signal is labeled as "Control signal" in FIG. 4.

The description provided herein below is based on the embodiment described in FIG. 3.

In FIG. 4, the received RF signal (i.e., the first RF signal or the second RF signal) comprises information contained sections 401a and 401 b and the null section 402. The received RF signal is labeled as "Received signal."

Depending on the intensity of the received RF signal Received signal, the gain control signal that controls the amplification gains of the first and second LNAs 302 and 312 and the amplifier 305 is supplied to the first and second LNAs 302 and 312 and the amplifier 305.

Based on the null section comprised in the received RF signal Received signal, the null control signal Control signal controls the gain control signal, which is supplied to the first and second LNAs 302 and 312 and the amplifier 305.

The null control signal Control signal may be supplied from inside or outside of the receiver 306.

The null control signal Control signal according to the present embodiment turns on at a section defined before and after the start of the null section 402 and turns off at a section defined before and after the end of the null section 402.

It will be apparent for those skilled in the art that the null control signal Control signal that controls the gain control signal can also be controlled by other methods in addition to the above-described turn-on/off method.

If the null control signal Control signal turns on right before the end of the information contained section 401a or 401b, the null control signal Control signal controls the gain control signal to be a certain gain control signal.

Particularly, the null control signal Control signal controls the gain control signal to maintain a predetermined consistent signal level.

The predetermined consistent signal level may be a signal level of the gain control signal that makes the signal level or the amplification gain value become '1' right before the end of the information contained section 401 a or 401b. The value '1' means a disallowed state of the amplification of the received RF signal.

The above control of the gain control signal by the null control signal Control signal can reduce an abnormal increase in the amplification gain at the null section 402.

According to various embodiments of the present invention, the T-DMB and DAB low IF receiver can reduce the manufacturing costs and allow an easier implementation of the single chip integration process by being able to remove the conventional SAW filter.

According to various embodiments of the present invention, the dual band T-DMB and DAB low IF receiver can receive the signals at the two frequency bands and remove the conventional SAW filter. Thus, the manufacturing costs can be reduced, and the receiver can be easily integrated into a single chip.

According to various embodiments of the present invention, the T-DMB and DAB low IF receiver can maintain the magnitude of the received signal at a consistent level.

The invention being thus described, it will be obvious that the same may be varied in many ways. Such variations are not to be regarded as a departure from the spirit and scope of the invention and all such modifications as would be obvious to one skilled in the art are intended to be included within the scope of the following claims.

## Claims

1. A terrestrial-digital multimedia broadcasting (T-DMB) and digital audio broadcasting (DAB) low intermediate frequency (IF) receiver comprising:
a low noise amplifier (LNA) suppressing a noise signal of a received radio frequency (RF) signal and amplifying the received RF signal, wherein the received RF signal includes a T-DMB signal or a DAB signal;
an image rejection down-conversion mixer converting a frequency band of the RF signal outputted from the LNA into a low IF band;
a low pass filter filtering a low frequency band of a signal outputted from the image rejection down-conversion mixer;
an amplifier amplifying a signal outputted from the low pass filter;
a local oscillator generating a frequency for the down-conversion and supplying the frequency to the image rejection down-conversion mixer;
a phase-locked loop moving the frequency of the local oscillator to a certain frequency and locking the certain frequency; and
an automatic gain controller (AGC) controlling amplification gains of the LNA and the amplifier,
wherein the LNA, the image rejection down-conversion mixer, the low pass filter, the amplifier, the AGC, the local oscillator, and the phase-locked loop are integrated in a monolithic semiconductor integrated circuit substrate; the AGC supplies a gain control signal to the LNA and the amplifier according to the magnitude of the RF signal; and the gain control signal is controlled by a null control signal based on a null signal comprised in the RF signal.

2. The T-DMB and DAB low IF receiver of claim 1, wherein the null control signal controls the gain control signal at a section of the null signal.

3. The T-DMB and DAB low IF receiver of claim 2, wherein the null control signal controls the gain control signal to have a consistent signal level at the section of the null signal.

4. The T-DMB and DAB low IF receiver of claim 3, wherein the signal level is a signal level of the gain control signal prior to receiving the null signal.

5. The T-DMB and DAB low IF receiver of claim 1, wherein the RF signal comprises a signal at one frequency band of a Band-III ranging between about 174 MHz and about 245 MHz or an L-band ranging between about 1,450 MHz and about 1,492 MHz.

6. A dual band terrestrial-digital multimedia broadcasting (T-DMB) and digital audio broadcasting (DAB) low intermediate frequency (IF) receiver comprising:
a first low noise amplifier (LNA) suppressing a noise signal of a received first radio frequency (RF) signal and amplifying the received first RF signal, wherein the received first RF signal includes a T-DMB signal;
a second low noise amplifier (LNA) suppressing a noise signal of a received second radio frequency (RF) signal and amplifying the received second RF signal,
wherein the received second RF signal includes a DAB signal;
an image rejection down-conversion mixer converting frequency bands of the first and second RF signals respectively outputted from the first and second LNAs into a low IF band;
a low pass filter filtering a low frequency band of a signal outputted from the image rejection down-conversion mixer;
an amplifier amplifying a signal outputted from the low pass filter;
a local oscillator generating a frequency for the down-conversion and supplying the frequency to the image rejection down-conversion mixer;
a phase-locked loop moving the frequency of the local oscillator to a certain frequency and locking the certain frequency; and
an automatic gain controller (AGC) controlling amplification gains of the first and second LNAs and the amplifier,
wherein the first and second LNAs, the image rejection down-conversion mixer, the low pass filter, the amplifier, the AGC, the local oscillator, and the phase-locked loop are integrated in a monolithic semiconductor integrated circuit substrate; the AGC supplies a gain control signal to the first and second LNAs and the amplifier according to the magnitude of the first and second RF signals; and the gain control signal is controlled by a null control signal based on a null signal comprised in each of the first and second RF signals.

7. The dual band T-DMB and DAB low IF receiver of claim 6, wherein the null control signal controls the gain control signal at a section of the null signal.

8. The dual band T-DMB and DAB low IF receiver of claim 7, wherein the null control signal controls the gain control signal to have a consistent signal level at the section of the null signal.

9. The dual band T-DMB and DAB low IF receiver of claim 8, wherein the signal level is a signal level of the gain control signal prior to receiving the null signal.

10. The dual band T-DMB and DAB low IF receiver of claim 6, wherein the first RF signal comprises a signal at a Band-III frequency band ranging between about 174 MHz and about 245 MHz; and the second RF signal comprises a signal at an L-band frequency band ranging between about 1,450 MHz and about 1,492 MHz.
